# FASCICULE DE BREVET EUROPEEN

(11) **EP 0 274 292 B1**
(45) Date de publication et mention de la délivrance du brevet: **17.03.1993**
(21) Numéro de dépôt: 87402633.9
(22) Date de dépôt: 24.11.1987
(51) Int. Cl.: H05K 7/14

(54) **Module électronique de puissance pour convertisseur statique**
Elektronisches Leistungsmodul für statischen Umsetzer
Electronic power module for a static converter

(30) Priorité: 16.12.1986 FR 8617710
(43) Date de publication de la demande: 13.07.1988
(73) Titulaire: MERLIN GERIN, F-38050 Grenoble Cédex (FR)
(72) Inventeur: Fiorina, Jean-Noel, F-38050 Grenoble Cédex (FR); Denis, Hervé, F-38050 Grenoble Cédex (FR)
(74) Mandataire: Hecké, Gérard

(56) Documents cités:
- DE-A- 2 747 712
- DE-A- 3 503 813
- FR-A- 2 011 668
- FR-A- 2 416 621

## Description

L'invention concerne un module électronique de puissance, notamment pour convertisseur statique, équipé d'un bloc radiateur a semelle de dissipation thermique, en matériau métallique bon conducteur de la chaleur, comprenant une face d'appui servant de support aux composants électroniques de puissance, et une face opposée dotée d'ailettes de refroidissement.

Les modules de l'art antérieur nécessitent généralement un câblage compliqué pour la connexion des différents composants électroniques du convertisseur, et pour le raccordement avec des modules juxtaposés ou des circuits d'utilisation. Il en résulte un encombrement important du boîtier dans lequel est intégré le bloc radiateur de chaque module.

Le document DE-A-3.503.813 décrit un boîtier pour la réception de cartes électroniques de télécommunication, dans lequel le côté extérieur de la face avant est doté d'ailettes de refroidissement, et la face arrière comporte une ouverture pour la connexion électrique. Chaque face latérale du boîtier est pourvue d'une rainure de guidage pour faciliter l'insertion dans une armoire.

L'objet de l'invention consiste à réduire l'encombrement d'un module électronique de puissance, et à réaliser un module compact et standard quel que soit le type de convertisseur.

Le module électronique selon l'invention est caractérisé en ce que:
la semelle de dissipation thermique comporte une paire de flasques parallèles, fixés latéralement sur les bords opposés de la semelle selon une direction perpendiculaire à la face d'appui, et une plaque de connexion équipée de contacts d'embrochage connectés électriquement aux composants électroniques, ladite plaque de connexion étant réalisée en matériau isolant et s'étendant entre les flasques pour constituer la face arrière du module,
- l'ensemble semelle, plaque de connexion et flasques est agencé en tiroir parallélépipédique susceptible de coopérer à translation avec un socle fixe de raccordement par embrochage des contacts de la plaque dans des broches conjuguées du socle,
- chaque flasque du module est muni d'une rainure longitudinale assurant le guidage du tiroir lors de l'embrochage par coulissement le long d'une glissière solidaire du socle de raccordement.
- des moyens de détrompage comportent une série de pions et d'orifices répartis sur la plaque de connexion et le socle, de manière à établir un codage de raccordement prédéterminé des contacts du module avec les broches alignées du socle.

Les flasques métalliques se trouvent en bon contact thermique avec la semelle et participent avec les ailettes à la dissipation de la chaleur engendrée par les composants électroniques.

Un tel agencement du module sous forme de tiroir facilite l'embrochage sur le socle de raccordement et évite l'utilisation d'un boîtier spécial de logement de l'ensemble. Il suffit d'adjoindre une poignée de préhension sur la face avant du module pour assurer l'embrochage et le débrochage.

Toute erreur de raccordement est supprimée par l'utilisation de moyens de détrompage.

Le guidage en translation du tiroir est assure par les deux glissières du socle pendant toute la course de déplacement du module. Un centrage précis est de plus exercé sur la plaque de connexion lors de l'insertion des contacts d'embrochage dans les broches fixes du socle.

Les contacts d'embrochage de la plaque de connexion du module sont avantageusement formés par des contacts à tulipes ou des pinces.

Le socle fixe de raccordement comprend au moins une plaque support des broches d'embrochage, ladite plaque support en matériau isolant étant intercalée entre deux consoles verticales prolongées par deux bras rectilignes constituant lesdites glisières coopérant à coulissement avec les rainures de guidage des flasques lors de l'embrochage du tiroir.

L'ensemble console et glissière correspondante est réalisé par moulage d'une pièce unique isolante en forme de T, la console ayant des organes d'emboîtement autorisant un montage modulaire du socle de raccordement.

Le montage des composants électroniques peut s'effectuer en n'importe quel endroit de la semelle du bloc radiateur grâce à la présence de plusieurs rainures parallèles s'étendant sur toute la longueur du bloc.

La fixation des composants intervient au moyen de vis autotaraudeuses vissées dans les rainures.

D'autres avantages et caractéristiques ressortiront plus clairement de la description qui va suivre d'un mode de réalisation de l'invention, donné à titre d'exemple non limitatif et représenté aux dessins annexés, dans lesquels:
- la figure 1 représente le schéma électrique unifilaire d'un système d'alimentation sans coupure;
- la figure 2 est une vue schématique en élévation de la cellule après enlèvement de la face avant;
- la figure 3 montre une vue en coupe selon la ligne III-III de la figure 2;
- la figure 4 est une vue en perspective du socle fixe de raccordément associé à un tiroir mobile embrochable;
- les figures 5 à 8 montrent les vues en perspective des opérations successives de réalisation d'un tiroir embrochable;
- la figure 9 est une vue éclatée en perspective d'un tiroir complètement équipé;
- les figures 10 A, 10 B, 10 C, représentent les vues en élévation de la face arrière d'une plaque de connexion d'un tiroir, respectivement pour un module mutateur d'un onduleur, pour un module redresseur chargeur, et pour un module normal secours à contacteur statique;
- les figures 11 et 12 montrent deux montages possibles des composants électroniques de puissance sur la semelle radiateur d'un tiroir;
- la figure 13 représente une vue en perspective d'un élément constitutif du socle de raccordement;
- la figure 14 montre une vue en perspective d'une plaque non équipée du socle de raccordement;
- la figure 15 représente une vue partielle en perspective à échelle agrandie de l'arrière d'un tiroir lors de l'embrochage dans le socle de raccordement;
- la figure 16 représente une variante de la cellule selon la figure 2.

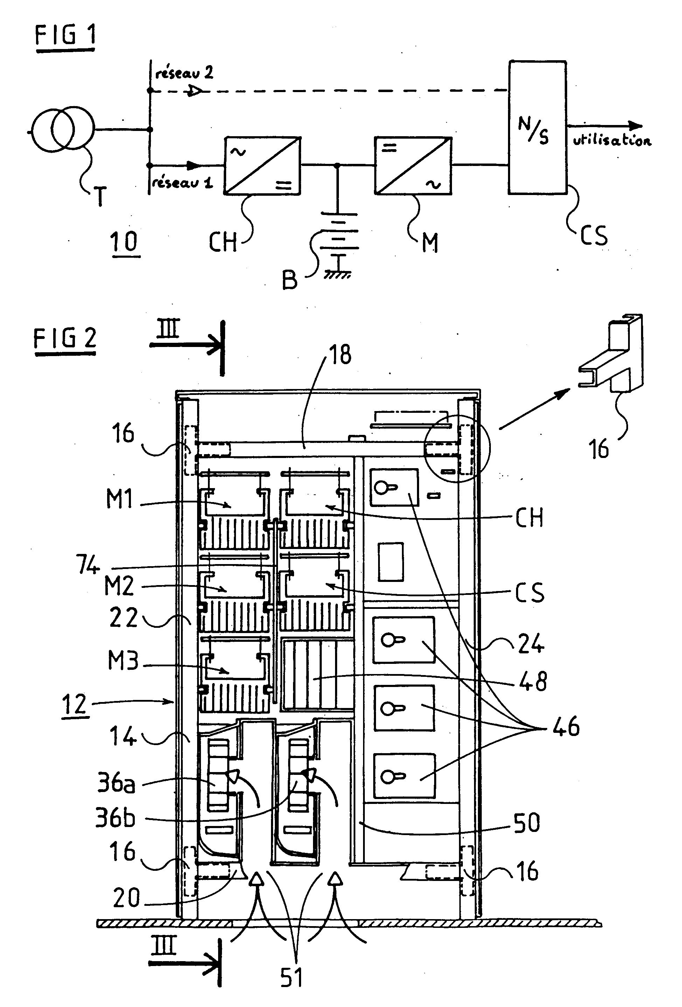

La figure 1 montre le schéma électrique unifilaire d'un système d'alimentation statique 10 sans coupure, comportant un redresseur chargeur CH, raccordé à un premier réseau 1, un onduleur M pour la conversion continu/alternatif et une batterie B d'accumulateurs disposée en tampon. La batterie B constitue un stock d'énergie disponible en permanence aux bornes d'entrées de l'onduleur M. Un dispositif inverseur normal secours N/S disposé entre l'onduleur M et l'utilisation est équipé d'un contacteur statique CS pour assurer le passage automatique et sans coupure du premier réseau 1 à un deuxième réseau 2. Le fonctionnement d'une telle alimentation est bien connu, et il suffit de rappeler qu'en présence de la tension sur le premier réseau 1, l'énergie est fournie à l'utilisation à travers le redresseur-chargeur CH et l'onduleur M. La batterie B est maintenue en permanence en état de charge par le redresseur-chargeur CH qui assure la conversion alternatif continu. A la disparition de la tension sur le premier réseau 1, l'alimentation de l'onduleur M est transféré instantanément et sans aucune perturbation pour l'utilisation du redressseur-chargeur CH vers la batterie B.

La batterie B fournit l'énérgie nécessaire à l'onduleur M dans les limites de son autonomie. Après retour de la tension sur le premier réseau 1, le redresseur-chargeur CH alimente à nouveau l'onduleur M, et assure la recharge de la batterie B.

En cas de surcharge du côté utilisation ou de défaut d'alimentation, le récepteur de l'utilisation est immédiatement connecté au deuxième réseau 2 par l'inverseur N/S à contacteur statique CS, et ne subit aucune perturbation. Le retour sur l'onduleur M s'opère automatiquement en fin de surcharge.

Les deux réseaux 1 et 2 du système d'alimentation 10 statique peuvent être raccordés à un transformateur T monophasé ou triphasé d'un tableau général à basse tension, dont l'appareillage de protection n'a pas été représenté.

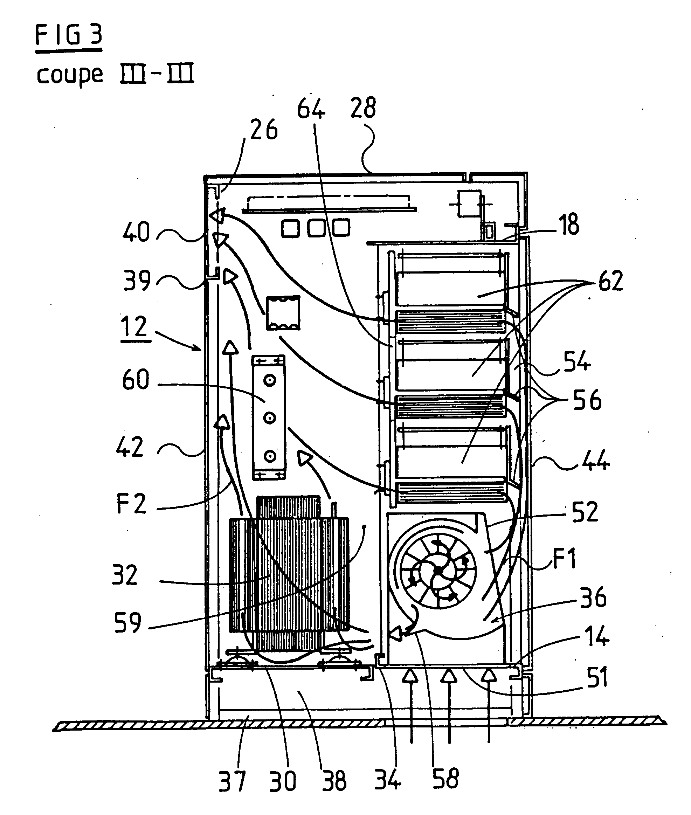

Le système d'alimentation statique 10 est logé dans une cellule 12 (figures 2 et 3) ayant un châssis 14 métallique en forme de parallélépipède droit. L'ossature antérieure au châssis 14 comporte quatre équerres 16 d'assemblage en forme de T, susceptibles de s'emboîter à chaque angle, dans des traverses supérieure 18 et inférieure 20, et dans des flasques 22, 24, verticaux opposées, parallèles deux à deux. L'ossature postérieure du châssis 14 comprend une traverse supérieure 26 servant de support au couvercle 28, et une plaque 30 horizontale de support d'un transformateur 32 associé à la commande de l'onduleur M. La traverse inférieure 20 fait partie d'une plaque 34 horizontale de support d'un groupe de ventilation 36. Les deux plaques 30, 34, sont coplanaires et sont séparées verticalement du fond 37 de la cellule 12 par un vide 38.

La traverse supérieure 26 de l'ossature postérieure comprend un orifice 39 d'échappement équipé d'une grille 40 de ventilation faisant communiquer le volume supérieur de la cellule 12 avec le milieu extérieur. Un panneau 42 arrière relie la traverse 26 supérieure à la plaque 30 inférieure, et s'étend parallèlement à la face avant 44 de la cellule 12.

La face avant 44 est pourvue à gauche d'une première porte d'accès aux différents sous-ensembles électroniques du système d'alimentation statique 10 comprenant les modules mutateurs M1, M2, M3 de l'onduleur M, le module redresseur-chargeur CH, et le module inverseur normal secours à contacteur statique CS, et à droite une deuxième porte pour l'accès à l'appareillage électrique 46 de protection et d'isolement, comportant des sectionneurs, interrupteurs ou disjoncteurs. Un panier 48 à cartes électroniques de surveillance et de commande est disposé sous le module à contacteur statique CS et à côté du mutateur inférieur M3 associé à l'une des phases de l'onduleur M.

Un cadre 50 vertical intermédiaire (figure 2) sépare les différents sous-ensembles électroniques de l'appareillage électrique 46. Chaque porte à axe vertical est supporté par deux charnières (non représentées) encastrées dans les deux équerres 16 d'assemblage disposées d'un même côté de l'ossature antérieure du châssis 14.

Le groupe de ventilation 36 est agencé dans le volume inférieur de la cellule 12 du côté de la porte de gauche et comporte une paire de ventilateurs 36 a, 36 b, disposés côte à côte sur la plaque 34. L'air de ventilation des deux ventilateurs 36 a, 36 b est aspiré latéralement à travers un orifice d'àdmission 51 de l'espace aval du vide 38, et est refoulé vers l'orifice 39 d'échappement selon deux trajets internes de refroidissement, indiqués par les flèches F1 et F2 (figure 3). Le premier trajet F1 provient de l'orifice principal 52 de refoulement des ventilateurs 36 a, 36 b, et assure la mise en pression de l'espace antérieur 54 de la cellule 12 situé entre les sous-ensembles électroniques et la face avant 44. Il en résulte une circulation forcée horizontale de l'air dans le sens de la profondeur de la cellule, de manière à refroidir efficacement les différents modules M1, M2, M3, CH et CS constitutifs des sous-ensembles électroniques, ainsi que le panier 48 à cartes. La circulation horizontale de l'air est favorisée par la présence de grilles 56 de turbulence, fixées à la partie antérieure des modules. Chaque grille 56 est légèrement inclinée vers le bas, et fait saillie dans l'espace 54 pour intercepter l'écoulement ascendant de l'air en provenance de l'orifice principal 52 de refoulement.

Le deuxième trajet F2 de l'air est engendré par un orifice de refoulement secondaire 58 des ventilateurs 36 a, 36 b, dirigé vers le transformateur 32 de l'onduleur M, situé dans le compartiment arrière 59 inférieur de la cellule 12. L'orifice secondaire 58 est plus petit que l'orifice principal 52 de refoulement et les deux trajets F1, F2 d'air de refroidissement sont indépendants l'un de l'autre en étant agencés en parallèle entre les orifices de refoulement 52, 58 des ventilateurs 36 a, 36 b, et l'orifice d'échappement 39 de la cellule 12.

L'air de ventilation du deuxième trajet F2 assure en plus du refroidissement du transformateur 32, celui d'autres composants du système d'alimentation 10, notamment des condensateurs 60 de filtrage ménagés dans la zone médiane de la cellule 12 entre l'orifice d'échappement 39 et le transformateur 32.

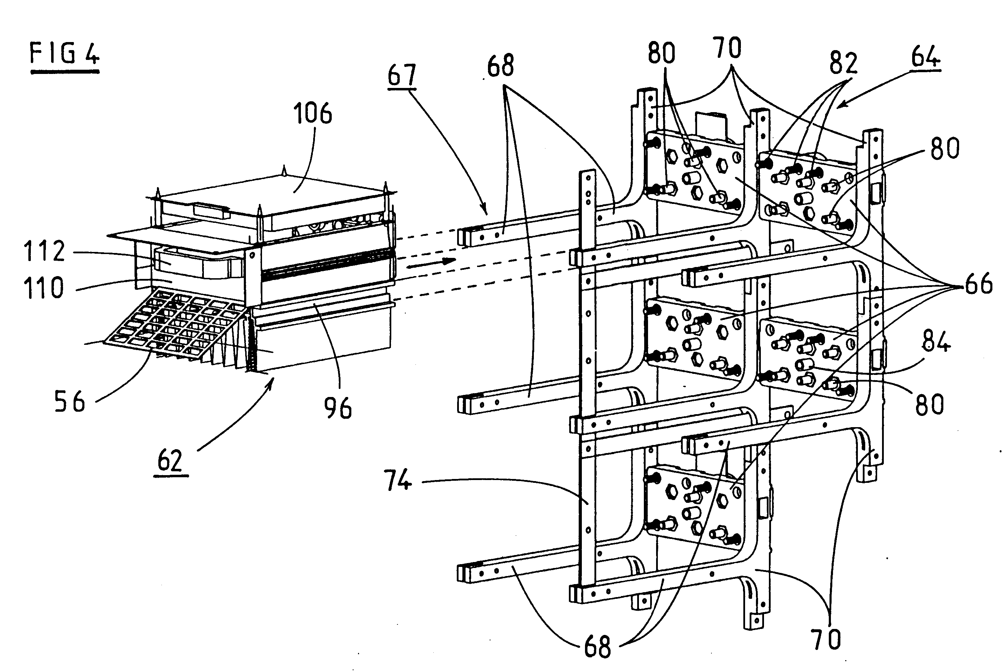

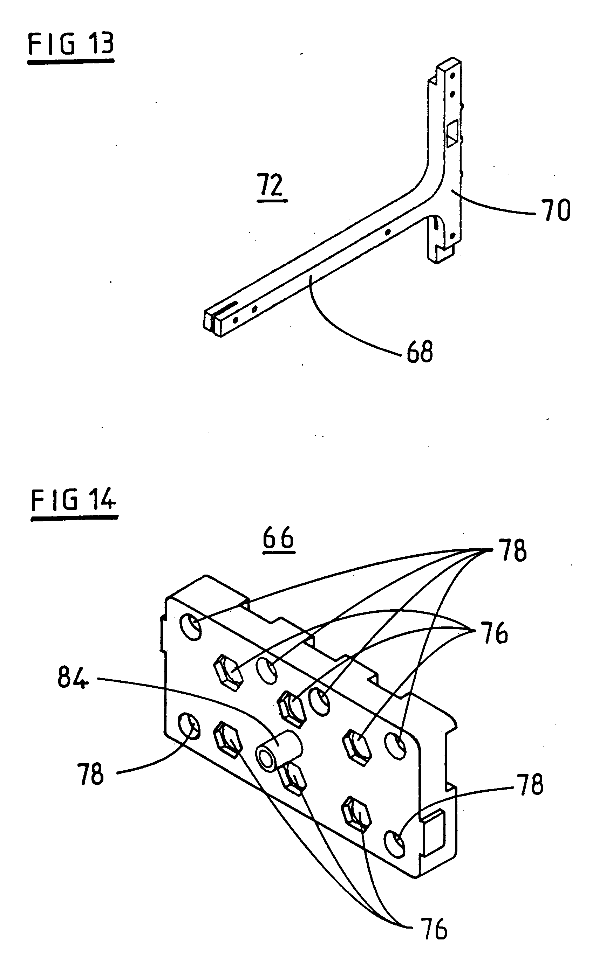

Les différents modules M1, M2, M3 de l'onduleur M, du redresseur-chargeur CH, et de l'inverseur normal secours à contacteur statique CS sont constitués par une pluralité de tiroirs 62 élémentaires juxtaposés, coopérant par embrochage avec un socle 64 fixe de raccordement (voir figures 3 et 4). Le socle 64 comporte une série de plaques supports 66 d'embrochage, en nombre égal à celui des tiroirs 62, et un dispositif de guidage 67 en translation des tiroirs 62 mobiles lors de la course d'embrochage. Le dispositif de guidage 67 est équipé de plusieurs glissières 68 parallèles en forme de bras rectilignes s'étendant vers la face avant 24 de la cellule 12 selon une direction perpendiculaire au plan de logement des plaques supports 66 d'embrochage. Les glissières 68 sont portées par des consoles 70 emboîtables entre lesquelles sont insérées les différentes plaques supports 66 d'embrochage. Une glissière 68 et la console 70 correspondante sont formées avantageusement par une pièce 72 unique standard en forme de T et en matériau isolant moulé, représentée en détail sur la figure 13. L'asssemblage modulaire préliminaire par emboîtement des différentes pièces 72 et des plaques supports 66 d'embrochage permet d'obtenir facilement une extension du socle 64 de raccordement en fonction du nombre de tiroirs 62 embrochables du système d'alimentation statique 10. L'assemblage définitif du socle 64 modulaire s'opère ensuite par une opération de rivetage des différentes consoles 70.

Les extrémités antérieures des glissières 68 superposées logées dans le plan intermédiaire vertical du socle 64 de raccordement, sont reliées entre elles par un conducteur de masse 74 (figures 2 et 4), susceptible d'interconnecter les radiateurs de refroidissement des différents sous-ensembles électroniques, en position embrochée des tiroirs 62. Ce conducteur de masse 74 fait partie d'un plan de masse interne, ayant fait l'objet d'une demande de brevet français N^{o} 86 15620 déposée le 5/11/1986 par la demanderesse.

Chaque plaque support 66 élémentaire du socle 64 de raccordement présente une structure rectangulaire en matériau isolant (voir figure 14), ayant six trous 76 hexagonaux réparties en deux séries superposées de trois trous, et six orifices 78 circulaires, dont quatre le long de l'arête supérieure, et deux aux angles inférieurs de la plaque 66. Les trous 76 sont destinés à recevoir des broches ou plots (80, figure 4) en matériau conducteur, tandis que les orifices 78 peuvent être obturés par des moyens de détrompage 82 en forme de tenons ou pions faisant saillie de la surface plane de la plaque support 66. La zone centrale de chaque plaque support 66 comporte de plus une douille 84 de centrage du tiroir 62 mobile.

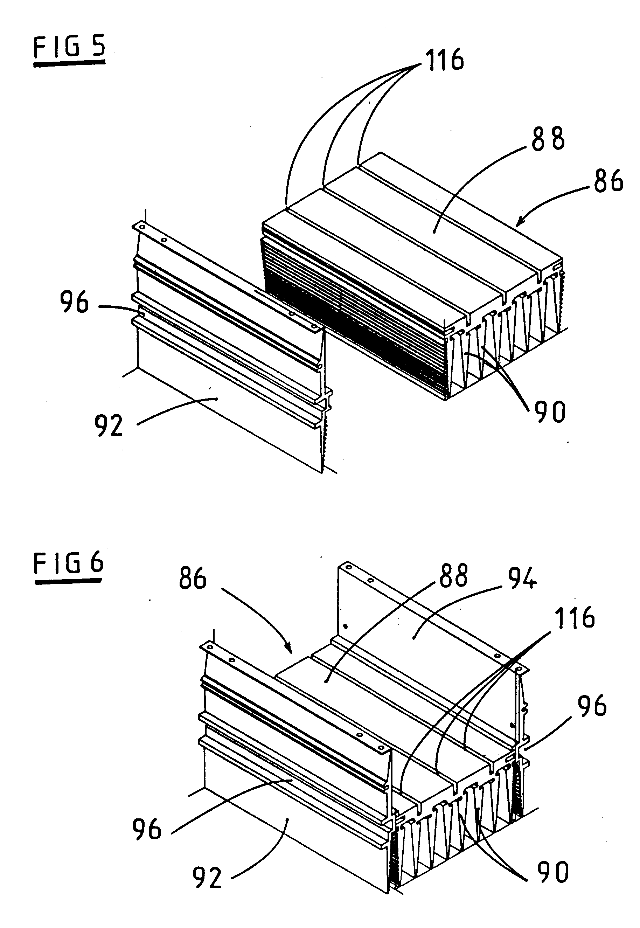

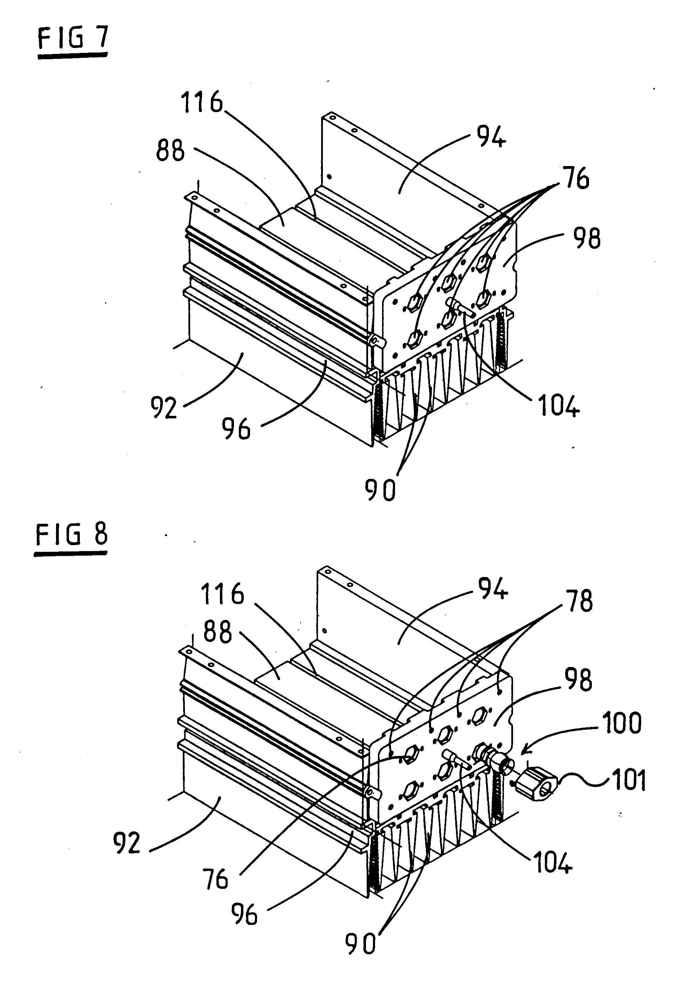

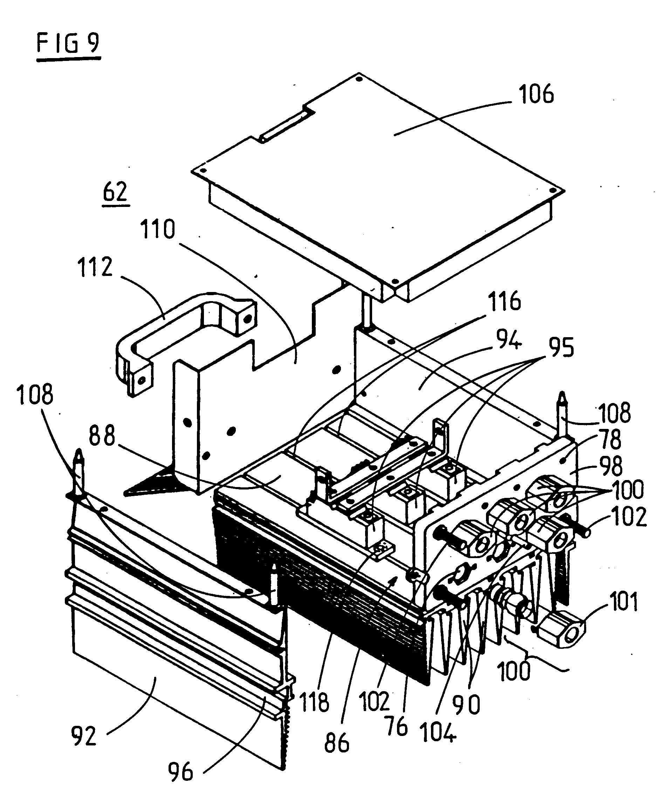

L'architecture d'un tiroir 62 embrochable est représentée aux figures 5 à 9. Chaque tiroir 62 comporte un bloc de base 86 en matériau métallique bon conducteur de la chaleur, ayant une semelle radiateur 88 à ailettes 90 de refroidissement, et deux flasques 92, 94, latéraux fixés verticalement sur les bords opposés de la semelle 88. La face supérieure de la semelle 88 radiateur est plane, et sert de support pour les composants électroniques 95 de puissance, notamment des transistors ou des thyristors. Les ailettes 90 de refroidissement sont échelonnées le long de la face inférieure de la semelle 88, et s'étendant vers le bas, selon une direction parallèle aux flasques 92, 94. La surface extérieure de chaque flasque 92, 94 du tiroir 62 est équipée d'une rainure 96 longitudinale de positionnement destinée à coopérer, lors de l'embrochage avec la glissière 68 correspondante du socle 64 de raccordement.

La face arrière de chaque tiroir 62 est pourvue d'une plaque 98 à contacts 100 du type tulipe; la structure de la plaque 98 est similaire à celle des plaques supports 66 (figure 14) du socle 64 fixe, et comporte six trous 76 hexagonaux pour la réception des contacts 100 à tulipe, et six orifices 78 pour la réception de moyens de détrompage 102. La zone centrale de la plaque 98 à contacts 100 comprend de plus une pièce 104 mâle de positionnement susceptible de s'engager dans la douille 84 de centrage de la plaque 66 conjuguée lors de l'embrochage des contacts 100 à tulipe dans les plots 80 correspondants du socle 64 de raccordement. Les contacts 100 à tulipe sont connectés aux composants électroniques semi-conducteurs 95 par des éléments de liaison (non représentés) se trouvant à l'intérieur du tiroir 62 au dessus de la semelle 88.

Une carte 106 électronique de commande des organes semi-conducteurs 95 sert de couvercle au tiroir 62 en reposant sur les flasques 92, 94 latéraux par l'intermédiaire de quatre entretoises 108. La face avant du tiroir 62 comporte une platine 110 à laquelle sont fixées la grille 56 de turbulence de l'air de ventilation, et une poignée 112 d'actionnement en translation du tiroir 62 embrochable. Chaque contact 100 à tulipe est protégé par un cache tulipe 101.

Les contacts 100 à tulipe de la plaque 98 des tiroirs 62 peuvent bien entendu être remplacés par des pinces d'embrochage.

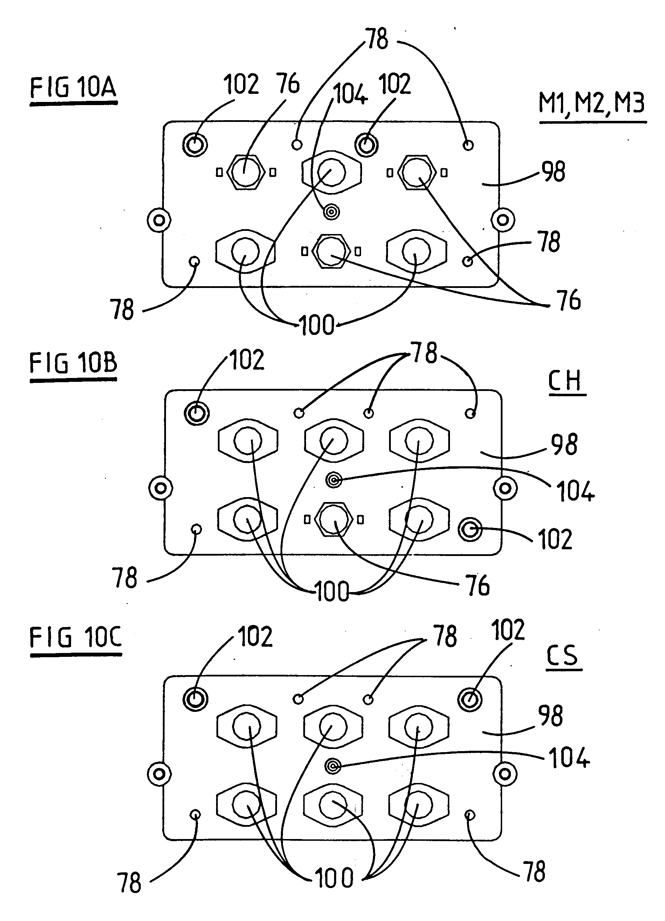

La répartition uniforme des trous 76 et orifices 78 sur les plaques 66, 98, respectives du socle 64 et des tiroirs 62 permet d'établir un codage précis de raccordement selon le type et la puissance des modules constitutifs du système d'alimentation statique 10. Les figures 10 A, 10 B et 10 C montrent la configuration de la plaque 98 équipée du système de raccordement et de détrompage d'un tiroir 62 mobile pour chaque type de module, susceptible de coopérer avec le socle 64 fixe de raccordement de la figure 4. Sur la figure 10 A relative à un module mutateur M1, M2, M3 d'une phase d'un onduleur M, les trois contacts 100 à tulipe de la plaque 98 peuvent s'engager dans les broches 80 conjuguées de l'une quelconque des trois plaques 66 superposés situées dans la colonne de gauche du socle 64 (figure 4). Les deux moyens de détrompage 102 de la plaque 98 peuvent s'introduire dans les orifices 78 restés libres dans les plaques 66 précitées, et réciproquement les quatre moyens de détrompage 82 des plaques 66 peuvent s'engager dans les quatre orifices 78 restés libres dans la plaque 98.

Sur la figure 10 B relative à un module redresseur chargeur CH, les cinq contacts 100 à tulipe de la plaque 98 peuvent s'embrocher dans les cinq broches 80 correspondantes de la plaque 66 située en haut à droite sur le socle 64 de la figure 4.

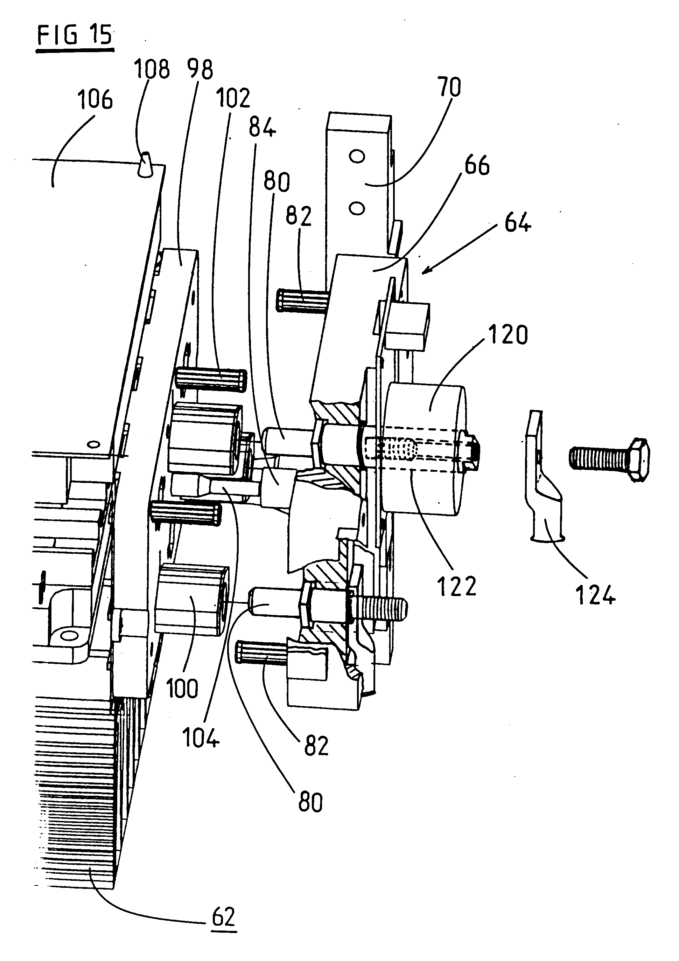

Sur la figure 10 C relative à un module inverseur normal-secours à contacteur statique CS, les six contacts 100 à tulipe de la plaque 98 peuvent s'embrocher dans les six broches 80 correspondantes de la plaque 66 située en bas à droite sur le socle 64 de la figure 4. La coopération réciproque des moyens de détrompage 82, 102, sur les deux plaques 66, 98, évite toute erreur de branchement lors du montage des différents sous-ensembles de la cellule 12, (voir figure 15). Les moyens de détrompage 82, 102, sont formés par des pions.

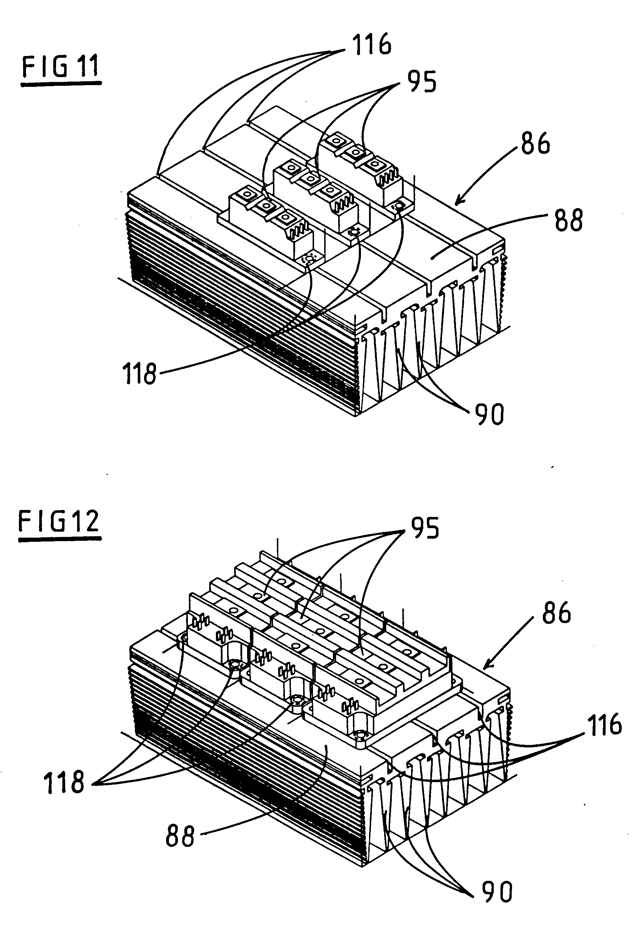

La face supérieure de la semelle 88 radiateur de chaque bloc de base 86 est munie de plusieurs rainures 116 longitudinales s'étendant parallèlement selon la direction des flasques 92, 94. La fixation des composants électroniques 95 de puissance sur la semelle 88 s'effectue au moyen de vis 118 autotaraudeuses pouvant s'engager dans les rainures 116 dans n'importe quelle position. Les composants 95 peuvent être agencés longitudinalement (figure 11) ou transversalement (figure 12) sur la semelle 88. Cette configuration à rainures 116 permet de standardiser le bloc de base 86 pour tous les types de modules, et évite toutes opérations de perçage de trous spécifiques, et de surfaçage supplémentaire pour l'enlèvement des bavures de perçage. Les rainures 116 sont réalisées automatiquement lors de la fabrication de la semelle 88 à base d'alliage d'aluminium.

Des capteurs de courant 120 (figure 15) peuvent équiper certains modules en étant fixés sur la face arrière du socle 64 de raccordement, à l'opposé des pions de détrompage 82. La connexion électrique des capteurs 120 s'opère au moyen de traversées 122 conductrices pouvant s'adapter sur des broches 80 conductrices de la plaque 66. Les capteurs de courant peuvent être constitués par des transformateurs d'intensité ou des cellules à effet Hall. Un départ 124 peut être fixé à l'extrémité postérieure de chaque traversée 122.

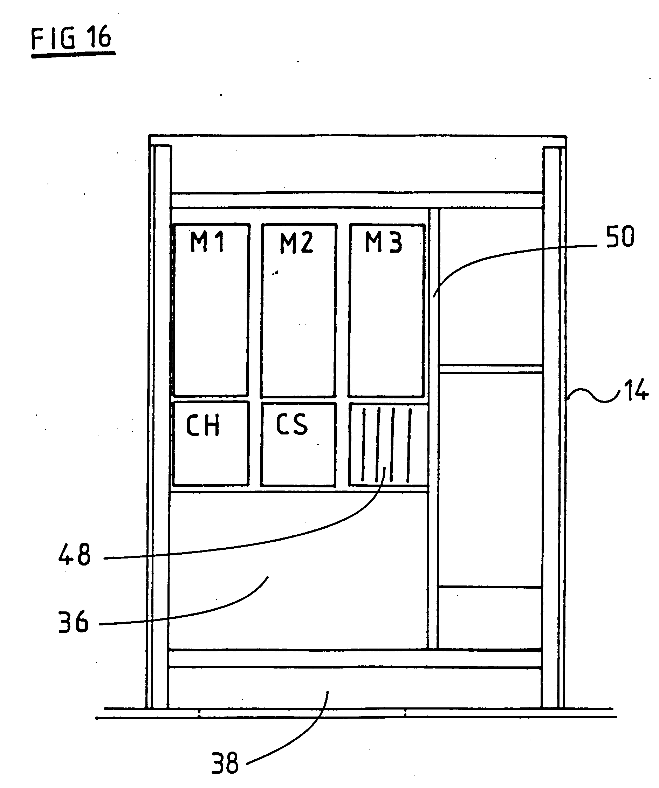

La répartition des différents modules M1, M2, M3, CH, CS sur le socle 64 de raccordement peut bien entendu être modifiée en fonction du type et de la puissance du système d'alimentation 10. La figure 16 montre une telle variante dans laquelle les trois modules mutateurs M1, M2 et M3 de l'onduleur M sont disposés respectivement au-dessus du module redresseur-chargeur CH, du module à contacteur statique CS, et du panier 48 à cartes électroniques.

## Revendications

1. Module électronique de puissance, notamment pour convertisseur statique, équipé d'un bloc radiateur à semelle (88) de dissipation thermique, en matériau métallique bon conducteur de la chaleur, comprenant une face d'appui servant de support aux composants électroniques (95) de puissance, et une face opposée dotée d'ailettes (90) de refroidissement,
caractérisé en ce que:
La semelle (88) de dissipation thermique comporte une paire de flasques (92, 94) parallèles, fixés latéralement sur les bords opposés de la semelle (88) selon une direction perpendiculaire à la face d'appui, et une plaque (98) de connexion équipée de contacts (100) d'embrochage connectés électriquement aux composants électroniques (95), ladite plaque de connexion (98) étant réalisée en matériau isolant et s'étendant entre les flasques (92, 94) pour constituer la face arrière du module,
- l'ensemble semelle, plaque de connexion et flasques est agencé en tiroir parallélépipédique susceptible de coopérer à translation avec un socle (64) fixe de raccordement par embrochage des contacts (100) de la plaque (98) dans des broches (80) conjuguées du socle (64),
- chaque flasque (92, 94) du module est muni d'une rainure (96) longitudinale assurant le guidage du tiroir lors de l'embrochage par coulissement le long d'une glissière (68) solidaire du socle (64) de raccordement.
- des moyens de détrompage comportent une série de pions (102, 82) et d'orifices (78) répartis sur la plaque (98) de connexion et le socle (64), de manière à établir un codage de raccordement prédéterminé des contacts (100) du module avec les broches (80) alignées du socle (64).

2. Module électronique selon la revendication 1, caractérisé en ce que la partie centrale de la plaque (98) de connexion à contacts (100) d'embrochage est munie d'un élément de positionnement (104) pouvant s'engager dans un organe de centrage (84) associé au socle (64).

3. Module électronique selon la revendication 1 ou 2, caractérisé en ce que les contacts (100) d'embrochage sont formés par des tulipes ou des pinces susceptibles d'être logées dans six trous (76) de la plaque (98) de connexion, lesdits trous (76) étant répartis en deux rangées horizontales superposées de trois trois, et que les pions de détrompage (102) peuvent être montés dans six orifices (78) de la plaque (98) de connexion du module, quatre des six orifices (78) étant disposés dans les angles de la plaque (98) de connexion de forme rectangulaire.

4. Module électronique selon la revendication 1, caractérisé en ce qu'une carte (106) électronique de commande des composants (95) de puissance repose sur les arêtes supérieures des deux flasques (92, 94) en s'étendant parallèlement à la face d'appui de la semelle (88) du bloc radiateur, et que la face avant du tiroir comporte une platine (110) équipée d'une poignée (112) d'actionnement.

5. Module électronique selon l'une des revendications 1 à 4, caractérisé en ce que le socle (64) fixe de raccordement comprend au moins une plaque support (66) des broches (80) d'embrochage, ladite plaque support (66) en matériau isolant étant intercalée entre deux consoles (70) verticales prolongées par deux bras rectilignes constituant lesdites glissières (68) coopérant à coulissement avec les rainures (96) de guidage des flasques (92, 94) lors de l'embrochage de tiroir.

6. Module électronique selon la revendication 5, caractérisé en ce que l'ensemble console (70) et glissière (68) correspondante est réalisé par moulage d'une pièce unique isolante en forme de T, la console (70) ayant des organes d'emboîtement autorisant un montage modulaire du socle (64) de raccordement.

7. Module électronique selon l'une des revendications 1 à 6, caractérisé en ce que la face d'appui de la semelle (88) du bloc radiateur est munie de plusieurs rainures (116) décalées, s'étendant parallèlement dans la direction des flasques (92, 94) sur toute la longueur du bloc, de manière à autoriser le montage de tout type de composants (95) électroniques au moyen de vis (118) autotaraudeuses.

8. Module électronique selon l'une des revendications 1 à 7, caractérisé en ce que la face arrière du socle (64) de raccordement, à l'opposé des pions (82) de détrompage, sert de support à un capteur de courant (120) connecté électriquement à la broche (80) correspondante au moyen d'une traversée (122) conductrice.

## Claims

1. An electronic power module, notably for a static converter, equipped with a heat-sink unit with a heat dissipation base-plate (88), made of good heat-conducting metallic material, comprising a bearing face acting as support for the electronic power components (95), and an opposite face equipped with cooling fins (90),
characterized in that :
- the heat-sink base-plate (88) comprises a pair of parallel flanges (92, 94), laterally fixed to the opposite edges of the base-plate (88) in a perpendicular direction to the support face, and a connecting plate (98) equipped with draw-in contacts (100) electrically connected to the electronic components (95), said connecting plate (98) being made of insulating material and extending between the flanges (92, 94) to form the rear face of the module,
- the assembly comprising the base-plate, connecting plate and flanges is arranged in a parallelipipedic rack designed to cooperate in translation with a fixed connecting base (64) by draw-in of the contacts (100) of the plate (98) into conjugate studs (80) of the base (64),
- each flange (92, 94) of the module is provided with a longitudinal groove (96) to guide the rack when draw-in takes place by sliding along a slide (68) securedly united to the connecting base (64).
- error prevention means comprise a series of pins (102, 82) and orifices (78) arranged on the connecting plate (98) and the base (64) in such a way as to establish a predetermined connection coding of the module contacts (100) with the aligned studs (80) of the base (64).

2. The electronic module according to claim 1, characterized in that the central part of the connecting plate (98) with draw-in contacts (100) is provided with a positioning device (104) able to engage in a centering part (84) associated with the base (64).

3. The electronic module according to claim 1 or 2, characterized in that the draw-in contacts (100) are formed by tulip-fingers or grips capable of being housed in six holes (76) of the connecting plate (98), said holes (76) being arranged in two superposed horizontal rows of three holes, and that error prevention pins (102) can be fitted in six orifices (78) of the module connecting plate (98), four of the six orifices (78) being located at the corners of the rectangular-shaped connecting plate (98).

4. The electronic module according to claim 1, characterized in that a printed circuit board (106) controlling the power components (95) is fitted on the upper edges of the two flanges (92, 94) extending parallel to the support face of the heat-sink unit base-plate (88), and that the rack front panel comprises a mounting plate (110) equipped with an actuating handle (112).

5. The electronic module according to one of the claims 1 to 4, characterized in that the fixed connecting base (64) comprises at least one support plate (66) of the draw-in studs (80), said support plate (66) made of insulating material being inserted between two vertical brackets (70) extended by two straight arms constituting said slides (68) cooperating in sliding with the guide grooves (96) of the flanges (92, 94) when the rack is drawn-in.

6. The electronic module according to claim 1, characterized in that the bracket (70) and corresponding slide (68) assembly is achieved by casting a single T-shaped insulating part, the bracket (70) having clip-on parts enabling modular assembly of the connecting base (64).

7. The electronic module according to one of the claims 1 to 6, characterized in that the support face of the heat-sink base-plate (88) is provided with several staggered grooves (116), extending parallel in the direction of the flanges (92, 94) over the whole length of the unit, so as to enable any type of electronic components (95) to be fitted by means of self-tapping screws (118).

8. The electronic module according to one of the claims 1 to 7, characterized in that the rear face of the connecting base (64), opposite the error prevention pins (82), acts as support for a current sensor (120) electrically connected to the corresponding stud (80) by means of a conducting bushing (122).

## Patentansprüche

1. Leistungselektronikmodul, insbesondere für eine Stromrichteranlage, das mit einem aus einem Metallwerkstoff guter Wärmeleitfähigkeit bestehenden Kühlkörper mit Wärmeableitelement (88) ausgerüstet ist, das eine Trägerseite zur Aufnahme Von elektronischen Bauteilen (95) sowie eine mit Kühlrippen versehene Unterseite (90) aufweist,
dadurch gekennzeichnet daß:
- das Wärmeableitelement (88) zwei parallele, an den gegenüberliegenden Seitenflächen des Wärmeableitelements (88) rechtwinklig zur Trägerseite befestigte Bleche (92, 94) sowie eine Anschlußplatte (98) mit Steckkontakten (100) aufweist, die elektrisch mit den elektronischen Bauteilen (95) verbunden sind, wobei die genannte Anschlußplatte (98) aus Isolierstoff besteht und zur Bildung der Modulrückwand zwischen den Seitenblechen (92, 94) angeordnet ist,
- die Einheit aus Wärmeableitelement, Anschlußplatte und Seitenblechen als quaderförmiger Einschub ausgeführt ist, der in einer Translationsbewegung mit einem feststehenden Sockel (64) zusammenwirkt, wobei die elektrische Verbindung durch Aufschieben der Steckkontakte (100) der Anschlußplatte (98) auf die entsprechenden Kontaktstifte (80) des Sockels (64) erfolgt,
- jedes Seitenblech (92, 94) des Moduls mit einer Längsnut (96) zur Führung des Einschubs beim Einfahren entlang einer fest mit dem Anschlußsockel (64) verbundenen Gleitschiene (68) versehen ist,
- Verwechslungsschutz-Vorrichtungen mit einer bestimmten Anzahl von Stiften (102, 82) und Bohrungen (78) auf der Anschlußplatte (98) und dem Sockel (64) angeordnet sind, so daß eine festgelegte Kodierung für den Anschluß der Steckkontakte (100) des Moduls an die entsprechend angeordneten Kontaktstifte (80) auf dem Sockel (64) erreicht wird.

2. Leistungselektronikmodul nach Anspruch 1, dadurch gekennzeichnet, daß der Mittelbereich der mit Steckkontakten (100) bestückten Anschlußplatte (98) mit einem Positionierelement (104) versehen ist, das mit einem auf dem Sockel (64) angebrachten Zentrierstift (84) zusammenwirkt.

3. Leistungselektronikmodul nach Anspruch 1 oder 2, dadurch gekennzeichnet, daß die Steckkontakte (100) als Kontakttulpen oder -zangen ausgeführt sind, die in den sechs Bohrungen (76) der Anschlußplatte (98) befestigt werden können, wobei die genannten Bohrungen (76) in zwei waagerechten Dreierreihen übereinander liegen, und daß die Verwechslungsschutz-Stifte (102) in sechs Bohrungen (78) der Anschlußplatte (98) des Moduls befestigt werden können, wobei vier der sechs Bohrungen an den Eckpunkten der rechteckigen Anschlußplatte (98) angeordnet sind.

4. Leistungselektronikmodul nach Anspruch 1, dadurch gekennzeichnet, daß eine Elektronikkarte (106) zur Ansteuerung der Leistungsbauelemente (95) auf den Oberkanten der beiden Seitenbleche (92, 94) aufliegt und parallel zur Trägerseite des Wärmeableitelements (88) des Kühlkörpers angeordnet ist, und daß an der Frontseite des Einschubs eine Platte (110) mit einem Handgriff (112) zum Ein- und Ausfahren des Einschubs angebracht ist.

5. Leistungselektronikmodul nach einem der Ansprüche 1 bis 4, dadurch gekennzeichnet, daß der feststehende Anschlußsockel (64) mindestens eine Trägerplatte (66) mit Kontaktstiften (80) aufweist, wobei die genannte Isolierstoff-Trägerplatte (66) zwischen zwei senkrechten Trägern (70) montiert ist, die in zwei gerade, die genannten Gleitschienen (68) bildenden Stützen übergehen, die beim Einfahren des Einschubs gleitend mit den Führungsnuten (96) der Seitenbleche (92, 94) zusammenwirken.

6. Leistungselektronikmodul nach Anspruch 5, dadurch gekennzeichnet, daß die Einheit aus Träger (70) und Gleitschiene (68) als T-förmiges Isolierstoff-Formteil aus einem Stück gefertigt wird, wobei der Träger (70) mit Paßelementen für einen modularen Aufbau des Anschlußsockels (64) versehen ist.

7. Leistungselektronikmodul nach einem der Ansprüche 1 bis 6, dadurch gekennzeichnet, daß die Trägerseite des Wärmeableitelements (88) des Kühlkörpers mit mehreren in einem bestimmten Abstand zueinander und parallel zur Ausrichtung der Seitenbleche (92, 94) über die gesamte Länge des Kühlkörpers verlaufenden Nuten (116) versehen ist, derart daß elektronische Bauelemente (95) jeder Art mit Hilfe von Schneidschrauben (118) darauf befestigt werden können.

8. Leistungselektronikmodul nach einem der Ansprüche 1 bis 7, dadurch gekennzeichnet, daß die Rückseite des Anschlußsockels (64) auf der gegenüberliegenden Seite der Verwechslungsschutz-Stifte (82) als Träger für einen Stromwandler (120) dient, der über eine leitende Durchführung (122) mit dem Kontaktstift (80) elektrisch verbunden ist.
